# FASCICULE DE BREVET EUROPEEN

(11) **EP 1 837 916 B1**
(45) Date de publication et mention de la délivrance du brevet: **06.01.2010**
(21) Numéro de dépôt: 07104318.6
(22) Date de dépôt: 16.03.2007
(51) Int. Cl.: H01L 29/786

(54) **Procédé de réalisation d'un transistor à canal comprenant du germanium**
Verfahren zum Herstellen eines Transistors mit einem Germanium enthaltenden Kanal
Method of manufacturing a transistor having a channel comprising germanium

(30) Priorité: 21.03.2006 FR 0602467
(43) Date de publication de la demande: 26.09.2007
(73) Titulaire: ST MICROELECTRONICS S.A., 92120 Montrouge (FR); STMicroelectronics (Crolles 2) SAS, 38920 Crolles (FR)
(72) Inventeur: Monfray, Stéphane, 38000, GRENOBLE (FR); Skotnicki, Thomas, 38920, CROLLES-MONTFORT (FR); Dutartre, Didier, 38240, MEYLAN (FR); Talbot, Alexandre, 38100, GRENOBLE (FR)
(74) Mandataire: Zapalowicz, Francis

(56) Documents cités:
- US-A1- 2005 029 603
- US-A1- 2005 169 096
- TEZUKA T ET AL: "HIGH-MOBILITY STRAINED SIGE-ON-INSULATOR PMOSFETS WITH GE-RICH SURFACE CHANNELS FABRICATED BY LOCAL CONDENSATION TECHNIQUE" IEEE ELECTRON DEVICE LETTERS, IEEE SERVICE CENTER, NEW YORK, NY, US, vol. 26, no. 4, avril 2005 (2005-04), pages 243-245, XP001230451 ISSN: 0741-3106
- MAEDA T ET AL: "HIGH MOBILITY GE-ON-INSULATOR P-CHANNEL MOSFETS USING PT GERMANIDE SCHOTTKY SOURCE/DRAIN" IEEE ELECTRON DEVICE LETTERS, IEEE SERVICE CENTER, NEW YORK, NY, US, vol. 26, no. 2, février 2005 (2005-02), pages 102-104, XP001222477 ISSN: 0741-3106

## Description

La présente invention concerne les circuits intégrés, et plus particulièrement les transistors MOS présentant un canal en silicium-germanium sur isolant.

Le développement de transistors de plus en plus petits a conduit à changer l'architecture des transistors afin de palier certains problèmes, notamment les effets de canaux courts (en anglais : Short Channel Effect (SCE)) ou bien encore l'abaissement de barrière induit par le drain (en anglais : Drain Induced Barrier Lowering (DIBL)). En particulier, des architectures à appauvrissement total (en anglais : Fully Depleted) ont été mises en oeuvre pour éviter ces effets. Or, dans le même temps, l'amélioration des performances des transistors a conduit à essayer de remplacer le silicium par le germanium qui présente une résistivité plus faible. La mise au point d'un transistor dont le canal comprend du germanium et est réalisé sur une couche isolante présente donc un intérêt important et permettrait d'obtenir un transistor avec des performances accrues.

Un procédé de réalisation d'un tel transistor est présenté dans l'article « High-Mobility Strained SiGe-on-Insulator pMOSFETs With Ge-Rich Surface Channels Fabricated by Local Condensation Technique » de Tezuka et al (IEEE, Electron Device Letters, vol.26, NO. 4, Avril 2005). L'article propose un procédé de réalisation d'un transistor sur un substrat de silicium sur isolant, dans lequel une couche de silicium-germanium est déposée sur le substrat et est recouverte d'une couche de silicium puis d'une couche d'oxyde de silicium. Une oxydation du silicium est alors réalisée de manière à oxyder une partie du silicium compris entre l'isolant du substrat et la couche d'oxyde de silicium. Les auteurs obtiennent alors une couche riche en germanium entre la couche isolante du substrat et la couche d'oxyde de silicium qui s'est formée durant l'oxydation. La couche d'oxyde de silicium est gravée de manière à former l'isolant de grille, puis la grille et les régions de source et de drain sont formées afin d'obtenir le transistor.

Cependant, ce procédé présente plusieurs inconvénients limitant son utilisation. Tout d'abord, le procédé nécessite la réalisation du transistor sur un substrat de silicium sur isolant. En effet, durant l'oxydation du silicium de la couche de silicium-germanium, le silicium du substrat situé en-dessous est également oxydé. Il est donc difficile de mettre en oeuvre un tel procédé sur un substrat de silicium puisqu'il n'y aura plus de couche isolante permettant d'arrêter et de confiner les atomes de germanium durant la phase d'oxydation.

De plus, l'oxydation du silicium entraîne une migration des atomes de silicium vers la surface oxydée tandis que les atomes de germanium sont repoussés dans la direction opposée. Ces mouvements d'atomes ne garantissent pas une bonne qualité de surface entre la couche riche en germanium et la couche d'oxyde de silicium qui se forme durant l'oxydation. Or, cette interface est importante puisque la couche riche en germanium est utilisée comme canal du transistor et une partie de la couche d'oxyde de silicium est utilisée comme isolant de grille. L'apparition de défauts électriques liés aux défauts de surface entre le canal et l'isolant de grille est donc possible.

L'invention vise à remédier à ces inconvénients.

L'invention a également pour but de proposer un nouveau procédé permettant de réaliser un transistor avec un canal riche en germanium et avec une architecture à appauvrissement total, pouvant être réalisé facilement sur tout type de substrat et dont la formation du canal peut être facilement contrôlée.

Selon un aspect de l'invention, il est proposé un procédé de fabrication d'un transistor MOS comprenant :
a) la formation, au-dessus d'un substrat, d'une couche semiconductrice intermédiaire contenant un alliage de silicium et de germanium,
b) la réalisation des régions de source, de drain et de grille isolée du transistor, au-dessus de la couche intermédiaire,
c) l'oxydation de la couche intermédiaire à partir de sa surface inférieure de façon à augmenter la concentration de germanium dans la région de la couche semi-conductrice intermédiaire située sous l'isolant de grille, et formant ainsi le canal du transistor.

En d'autres termes, on réalise un transistor avec un canal riche en germanium par oxydation du silicium contenu dans la couche intermédiaire de silicium-germanium à partir de la surface inférieure de ladite couche intermédiaire. Les atomes de germanium sont donc amenés à migrer vers la surface supérieure de la couche intermédiaire de silicium-germanium, et sont stoppés par la couche d'isolant de grille. La migration des atomes durant l'étape d'oxydation est ainsi moins préjudiciable pour les performances du transistor puisque l'isolant de grille du transistor est déjà réalisé et n'est pas modifié durant cette étape. La migration des atomes de germanium vers l'isolant de grille qui est immobile conduit à limiter les défauts de surface entre le canal et l'isolant.

De plus, le transistor peut être réalisé sur tout type de substrat. En effet, durant la phase d'oxydation, les atomes de germanium s'éloignent du substrat et sont stoppés par une couche réalisée au-dessus de la couche intermédiaire de silicium-germanium. I1 est donc aisé de choisir le matériau de la couche d'arrêt (qui constituera l'isolant de grille) et il n'y a plus de contrainte particulière sur le type de substrat à utiliser.

Le procédé proposé permet de réaliser soit des transistors avec un canal en silicium-germanium sur isolant, soit des transistors avec un canal en germanium sur isolant. En effet, en oxydant durant un temps suffisant la couche intermédiaire de silicium-germanium, d'une part on condense le germanium, c'est-à-dire que l'on augmente la concentration de germanium, à proximité de l'isolant de grille, et d'autre part on oxyde le silicium restant. Il est ainsi possible d'obtenir un canal ne contenant plus que du germanium. Le procédé permet alors d'obtenir un transistor à canal en germanium sans nécessiter de dépôt de couche de germanium pur. Le canal en germanium est formé en condensant les atomes de germanium initialement présents dans la couche intermédiaire, dans la région située sous l'isolant de grille. On concentre donc le germanium dans un espace plus petit notamment en faisant réagir les autres atomes de la couche intermédiaire. Ce procédé permet de remplacer le dépôt de germanium pur par le dépôt de silicium-germanium qui plus facile, plus rapide et de meilleure qualité.

Selon un mode de mise en oeuvre, l'étape b) comprend la formation d'une couche supérieure sur la couche intermédiaire, et la réalisation des régions de source, de drain et de grille isolée sur ladite couche supérieure.

La couche supérieure n'est pas indispensable à la réalisation du transistor. En effet, on pourrait envisager de former l'oxyde ou diélectrique de grille directement sur la couche intermédiaire. Cependant cette couche supérieure présente l'avantage de permettre une meilleure interface avec l'isolant de grille. Par exemple, lorsque l'oxyde de grille est de l'oxyde de silicium et la couche supérieure est une couche de silicium, le dépôt d'une couche d'oxyde de silicium sur une couche de silicium permet de limiter les défauts de surface et d'obtenir une meilleure interface entre les deux couches. De plus, comme la migration des atomes de germanium durant la phase d'oxydation se fait à partir de la surface opposée de la couche intermédiaire de silicium-germanium, le procédé permet de conserver cette interface de bonne qualité entre la canal et la couche d'oxyde de silicium. La couche de silicium a pour principal objectif de permettre un dépôt de meilleure qualité de l'isolant de grille. I1 n'est donc pas nécessaire de réaliser la couche supérieure avec une épaisseur importante. De plus, cette couche est destinée à être enrichie en germanium durant la phase d'oxydation. Il est donc préférable de limiter la taille de la couche supérieure afin de limiter la quantité de silicium restant dans le canal du transistor. Enfin, une épaisseur trop importante de la couche supérieure pourrait permettre une oxydation localisée de celle-ci, ce qui conduirait à une épaisseur plus importante de l'isolant de grille qui comprend de l'oxyde de silicium.

Ainsi, de manière préférentielle, la couche supérieure est une couche de silicium formée par épitaxie et présentant une épaisseur inférieure à 4nm, par exemple 1 nm.

De manière préférentielle, la surface inférieure de la couche intermédiaire repose sur une couche sacrificielle formée au-dessus du substrat et l'étape c) comprend :
- la gravure de la couche sacrificielle de manière à obtenir un tunnel exposant la surface inférieure de la couche intermédiaire, et
- l'oxydation, dans le tunnel, de la surface inférieure de la couche intermédiaire.

Ce mode de mise en oeuvre permet de réaliser l'oxydation par contact de la couche à oxyder avec une atmosphère oxydante. Afin d'avoir accès à la surface inférieure de la couche intermédiaire à oxyder, une couche sacrificielle est réalisée sous la couche intermédiaire puis est gravée sélectivement afin de créer un tunnel exposant la surface inférieure de la couche intermédiaire. Il suffit alors de placer le circuit intégré dans une atmosphère oxydante pour réaliser l'oxydation.

De manière préférentielle, après l'oxydation de la surface inférieure de la couche intermédiaire, on remplit le tunnel avec un matériau diélectrique.

En effet, durant l'oxydation de la couche intermédiaire, une augmentation de l'épaisseur de la couche apparaît en raison de l'oxydation du silicium en oxyde de silicium. Toutefois, cette augmentation ne permet pas forcément de combler totalement le tunnel. Le dépôt d'un matériau diélectrique peut alors être effectué afin de créer une zone entièrement diélectrique sous le canal.

Selon un mode de mise en oeuvre, la couche sacrificielle comprend du silicium et est formée sur une première couche contenant un alliage de silicium et de germanium.

Ce mode de mise en oeuvre propose ainsi de réaliser la couche sacrificielle en silicium entre deux couches de silicium-germanium afin de permettre une gravure sélective de la couche sacrificielle. La couche sacrificielle permet de définir ainsi la taille et la position du tunnel qui va être formé, afin de réaliser dans un second temps l'étape d'oxydation.

De manière préférentielle, l'étape a) comprend la formation de la première couche, de la couche sacrificielle et de la couche intermédiaire par une épitaxie sans facette. De plus, la gravure de la couche sacrificielle comporte une gravure sélective par rapport à la première couche et à la couche intermédiaire.

On entend par épitaxie sans facette, un procédé d'épitaxie permettant d'éviter le recouvrement d'une couche par une autre au niveau des extrémités latérales. En particulier, lors de la croissance d'une couche par épitaxie, certains plans cristallographiques qui ne sont pas parallèles à la surface du substrat peuvent croître et créer une couche avec des extrémités obliques. Ces extrémités obliques, appelées facettes, sont à éviter car elles peuvent être complètement recouvertes par les couches suivantes et empêcher ainsi d'avoir accès latéralement à la couche. Il n'est alors plus possible de graver la couche par ses extrémités.

Selon un autre mode de mise en oeuvre, la couche sacrificielle est une couche diélectrique formée au-dessus du substrat.

Ce mode de mise en oeuvre permet d'utiliser les gravures sélectives de matériaux diélectriques par rapport aux matériaux semiconducteurs. En particulier, il est possible de réaliser la couche sacrificielle sur le substrat semi-conducteur qui ne sera pas gravé par la gravure sélective. La couche diélectrique définit alors la taille et la position du tunnel qui permet d'exposer la surface inférieure de la couche intermédiaire.

De manière préférentielle, la couche intermédiaire présente une épaisseur comprise entre 5nm et 15nm, de préférence inférieure à 10nm, et une proportion de germanium comprise entre 30% et 90%, de préférence supérieure à 50%.

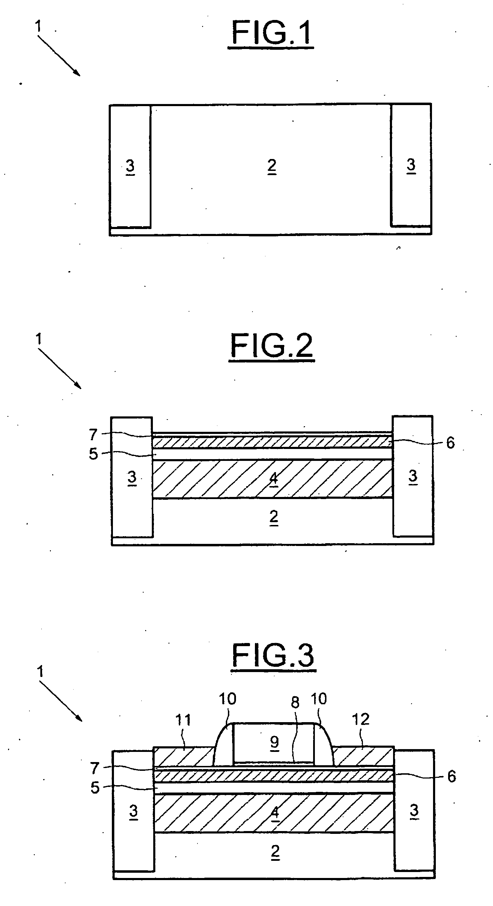

D'autres avantages et caractéristiques apparaîtront à l'examen de la description détaillée de deux modes de mise en oeuvre, nullement limitatifs, et des dessins annexés sur lesquels les figures 1 à 9 illustrent d'une façon très schématique, les principales étapes de deux modes de mise en oeuvre du procédé selon l'invention.

La figure 1 représente très schématiquement une coupe d'un circuit intégré 1 comprenant un substrat 2, par exemple en silicium, et deux zones d'isolation 3, par exemple de type tranchée peu profonde (STI : Shallow Trench Isolation).

La figure 2 représente la coupe du circuit intégré 1 après la réalisation de différentes couches selon un premier mode de mise en oeuvre du procédé selon l'invention. En particulier, après gravure du substrat 2 entre les zones 3, on réalise une première couche 4 comprenant du silicium-germanium, puis une couche sacrificielle 5 de silicium. La couche 4 peut être choisie de manière à présenter une proportion de germanium relativement faible, par exemple entre 20 et 40%. L'épaisseur de la couche 4 peut être comprise par exemple entre 20 et 40nm. L'épaisseur de la couche 5 peut être comprise entre 5 et 30nm. La couche 5 détermine l'épaisseur du tunnel et doit être adaptée de manière à ce que l'augmentation de volume des différentes couches durant l'oxydation ne remplisse pas prématurément le tunnel. Les couches 4 et 5 sont réalisées par exemple par épitaxie, selon un procédé sans facette, c'est-à-dire limitant l'apparition des facettes aux extrémités latérales des couches. Un tel procédé d'épitaxie sans facette est connu en soi, et l'homme du métier pourra par exemple se référer à l'article « Investigation of Facet Formation In RTCVD Si/SiGe Selective Epitaxie » de Talbot et al (ECS Proceedings, vol 2004-07, p.601) pour plus de précisions concernant un tel procédé de mise en oeuvre d'une épitaxie sans facette. En particulier, une diminution de la température, lors de la croissance par épitaxie des différentes couches, permet de limiter les vitesses de croissance des plans cristallographiques formant des facettes.

On réalise alors une couche intermédiaire 6 comprenant un alliage de silicium-germanium. La couche intermédiaire 6 présente une proportion élevée de germanium, comprise par exemple entre 30 et 90% selon la vitesse de croissance souhaitée et l'épaisseur voulue. En effet, plus la proportion de germanium dans la couche 6 est élevée, plus l'épaisseur de la couche 6 est faible et plus la durée de croissance est courte. La proportion de germanium ainsi que l'épaisseur sont donc adaptées aux conditions de dépôts et à la proportion de germanium souhaitée ultérieurement dans le canal du transistor. Préférentiellement, la couche 6 comprend une proportion de germanium supérieure à 50% et une épaisseur inférieure à 10 nm. La couche 6 est également réalisée par épitaxie, selon un procédé classique et connu de l'homme du métier. On pourra par exemple réaliser la couche 6 également selon une méthode d'épitaxie sans facette.

La couche intermédiaire 6 est alors recouverte par une couche supérieure 7 de silicium. La couche 7 peut également être réalisée par épitaxie, et présente une épaisseur inférieure à 4nm, de préférence inférieure à 2nm. La couche 7 n'est pas obligatoire pour la réalisation du transistor mais est préférable car elle facilite la réalisation de l'isolant de grille au-dessus de la couche 6. En particulier, selon le matériau utilisé pour réaliser l'isolant de grille (qui peut comprendre par exemple de l'oxyde de silicium SiO₂, ou bien un matériau à forte constante diélectrique (« High K »), ou bien une combinaison des deux), on pourra choisir en conséquence un autre matériau pour la couche 7 ou bien ne pas déposer de couche 7. Ainsi, dans le cas particulier où l'isolant de grille est de l'oxyde d'hafnium HfO₂, on pourra soit déposer une couche 7 comprenant préférentiellement de l'oxyde de silicium-germanium SiGeOₓ soit ne pas déposer de couche 7.

On procède alors à la réalisation classique de la grille isolée du transistor MOS (figure 3). Plus précisément, cette réalisation comporte tout d'abord la formation, sur la couche supérieure 7, d'un oxyde de grille 8, dans le cas présent de l'oxyde de silicium, puis la formation de la grille 9. Celle-ci est flanquée d'un premier type de régions isolantes ou espaceurs 10, par exemple en nitrure de silicium. Enfin, on réalise deux régions en silicium-germanium par une reprise d'épitaxie sur la couche supérieure 7. Cette épitaxie sélective est suivie d'une implantation classique de façon à former les régions 11 et 12 de source et de drain. Les régions 11, 12 de source et de drain peuvent comprendre par exemple une proportion de germanium comprise entre 20 et 30% et présentent avantageusement une épaisseur d'environ 30nm. En particulier, la taille des régions 11, 12 sera choisie de manière à ce qu'elles ne soient pas réduites de manière trop importante durant l'étape d'oxydation, afin qu'il soit toujours possible de réaliser facilement la prise de contact sur ces deux régions 11, 12.

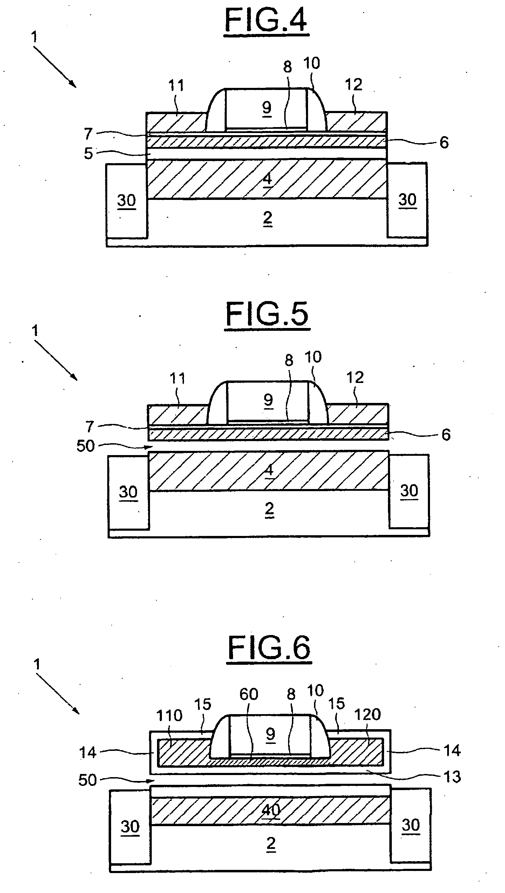

L'étape suivante consiste à graver, de manière classique pour l'homme du métier, les régions isolantes 3 de manière à exposer les extrémités latérales de la couche sacrificielle 5. Les extrémités latérales de la couche 5 peuvent être accessibles notamment grâce à l'utilisation du procédé d'épitaxie sans facette. On obtient donc le circuit intégré 1 avec des régions isolantes gravées 30 (figure 4).

On procède alors à la formation du tunnel par gravure sélective de la couche sacrificielle 5 par rapport aux couches 4 et 6. La gravure sélective de la couche 5 est connue en soi et réalisée par exemple par gravure plasma comprenant du tétrafluorométhane CF₄, de l'oxygène 0₂ et du difluorométhane CH₂F₂. Elle permet le retrait de la couche 5 qui est la seule couche en silicium. En particulier, la couche supérieure 7 n'est pas gravée car son épaisseur est trop fine pour permettre un retrait efficace et conséquent. De plus, la couche supérieure 7 n'est pas nécessairement formée par épitaxie sans facette, ce qui permet de recouvrir les extrémités latérales de la couche 7 et donc d'éviter la gravure de celle-ci.

La couche sacrificielle 5 est donc gravée sélectivement de manière à former un tunnel 50 exposant la surface inférieure de la couche intermédiaire 6 (figure 5).

L'étape suivante consiste à condenser le germanium dans la région de canal. On réalise donc une oxydation de la couche intermédiaire 6 à partir de sa surface inférieure. L'oxydation est effectuée sous atmosphère oxydante, à une température comprise préférentiellement entre 900°C et 1200°C. On pourra notamment se référer à l'article de Tezuka et al pour de plus amples détails concernant une telle méthode d'oxydation. L'oxydation de la surface inférieure de la couche 6 est possible grâce au tunnel 50. On forme ainsi une couche d'oxyde de silicium 13 à partir de la surface inférieure de la couche intermédiaire 6, mais également sur toutes les surfaces exposées qui contiennent du silicium. On obtient donc une couche d'oxyde de silicium 14 sur les surfaces latérales de la couche intermédiaire 6 et des régions 11 et 12 de source et de drain. On obtient également une couche d'oxyde de silicium 15 sur la surface supérieure des régions 11 et 12 de source et de drain et une couche d'oxyde de silicium 16 sur la surface supérieure de la première couche 4. Au fur et à mesure que les couches 13, 14, 15, 16 d'oxyde de silicium se forment, les couches 4, 6 et les régions 11, 12 diminuent en taille et s'enrichissent en germanium, pour donner des couches 40, 60 et des régions 110, 120 (figure 6). La couche supérieure 7 a disparu durant l'étape d'oxydation car les atomes de germanium de la couche intermédiaire 6 sont concentrés dans la région située sous le canal, c'est-à-dire dans la région où se trouve une partie de la couche supérieure 7. La couche 7 comprend donc du silicium-germanium, comme la partie non-oxydée de la couche 6, et les deux couches forment alors la région de canal 60.

La région 60 comprend les atomes de germanium initialement présents dans la couche intermédiaire 6, tandis que les atomes de silicium de la couche 6 et 7 ont été, au moins en partie, oxydés durant l'étape d'oxydation. Si l'on souhaite réaliser un transistor avec un canal 60 comprenant essentiellement du germanium, il suffit d'oxyder durant un temps suffisant les couches 6 et 7 afin de transformer presque tous les atomes de silicium, en oxyde de silicium. Les atomes de germanium restant formeront alors le canal du transistor 60.

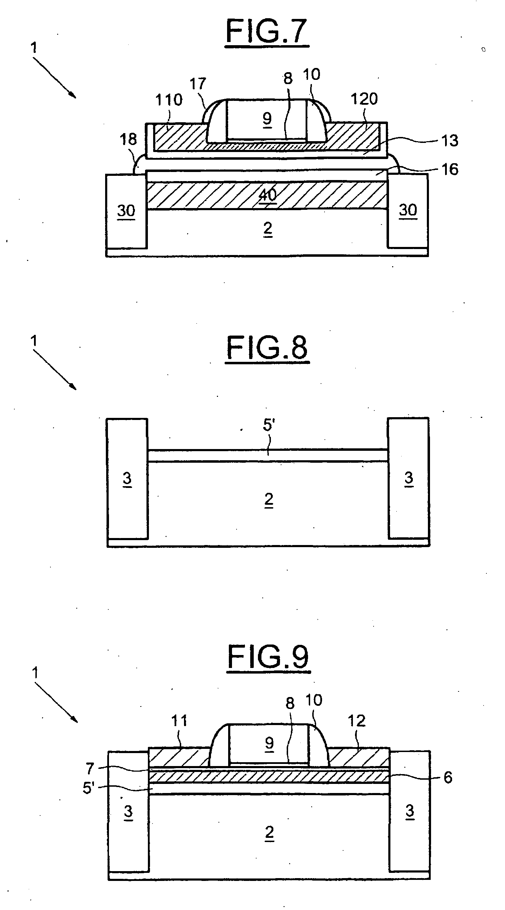

Une fois l'étape d'oxydation terminée, on grave de manière classique, la couche d'oxyde 15 de manière à accéder aux régions 110 et 120 de source et de drain. Puis on réalise un deuxième type de régions isolantes ou espaceurs 17, par exemple en nitrure de silicium. On peut remplir également le tunnel 50 avec un matériau diélectrique 18, par exemple du nitrure de silicium, afin de former une région complète 16, 18, 13 diélectrique sous les régions 60, 110, 120 de canal, de drain et de source (figure 7).

La suite du procédé de réalisation du transistor est classique, et comporte notamment les prises de contact sur les régions 110, 120, 9 de source, de drain et de grille.

On obtient alors, comme illustré sur la figure 7, un transistor à canal en silicium-germanium ou en germanium à appauvrissement total.

Ce transistor se situe sur un empilement de couches 16, 18, 13 reposant sur un substrat 2, cet empilement de couches étant diélectrique.

Par ailleurs, la couche isolante 8 de grille se situe au-dessus du canal 60 de silicium-germanium et n'a pas été modifiée depuis son dépôt sur la couche supérieure de silicium 7. L'interface entre la couche 8 et le canal 60 a donc gardé une qualité de surface analogue à celle entre la couche 8 et la couche 7.

La finesse de la couche de canal 60 est déterminée notamment par la quantité de germanium présent dans la couche intermédiaire initiale 6 et par la durée de l'oxydation. Cette finesse est choisie de manière à permettre géométriquement un bon contrôle des effets canaux courts.

Par ailleurs, l'utilisation de germanium dans le canal 60 va permettre d'améliorer la mobilité des porteurs de charges se déplaçant dans le canal 60.

De plus, la possibilité de réaliser localement par épitaxie les couches 4, 5 et 6 permet d'intégrer les transistors obtenus selon le procédé décrit dans des plaquettes de silicium ou de silicium sur isolant. Il est alors aisé de juxtaposer des transistors différents, correspondant à différentes technologies, selon les besoins.

Enfin, le procédé décrit permet la réalisation de l'oxyde de grille 8 sur la couche supérieure 7 de silicium, avant l'étape d'oxydation. Ainsi, les liaisons Si-O qui apparaissent à l'interface entre la couche supérieure 7 et l'oxyde de grille 8 sont stables et ne sont pas susceptibles d'être perturbées durant la concentration du germanium à proximité de cette interface. On évite ainsi des défauts éventuels, tels que les défauts électriques, à l'interface entre le semi-conducteur et l'oxyde de grille.

L'invention n'est pas limitée au mode de mise en oeuvre et de réalisation qui vient d'être décrit.

Ainsi, comme illustré sur les figures 8 et 9, il est possible de réaliser une couche sacrificielle 5' en matériau diélectrique, par exemple en oxyde de silicium. Il n'est alors plus nécessaire d'utiliser un procédé d'épitaxie sans facette (puisque la couche diélectrique n'est pas déposée par épitaxie). Il suffit ensuite de réaliser les étapes de formation des couches 6, 7, 8 et des régions 9, 10, 11, 12 pour obtenir un transistor analogue à celui représenté sur la figure 3. La réalisation du tunnel se fera alors par une gravure sélective du matériau diélectrique 5'. Cette gravure sélective est connue en soi et peut être réalisée par exemple par gravure chimique d'une solution d'acide fluorhydrique HF. Le reste du procédé pourra se faire de manière analogue au premier mode de mise en oeuvre décrit.

Il est également possible de réaliser le transistor selon le premier mode de mise en oeuvre décrit, sans réaliser les couches 4, 5 (et éventuellement 6, 7) par épitaxie sans facette. En particulier, il est possible de réaliser lesdites couches par épitaxie classique avant de réaliser les zones d'isolation 3 (STI), puis de graver (de manière connue pour l'homme du métier) les extrémités facettées de l'empilement, et enfin de réaliser, au niveau des zones gravées, les régions d'isolations 3. On obtient alors un circuit intégré analogue à celui représenté sur la figure 2 à partir duquel on peut reproduire les mêmes étapes du procédé que dans le premier mode de mise en oeuvre décrit. On veillera cependant, lors de la réalisation des régions isolantes 3, à utiliser un matériau diélectrique ne nécessitant pas de budget thermique important lors de sa réalisation, de manière à ne pas endommager les couches 4, 5 (et éventuellement 6, 7) réalisées par épitaxie et pouvant présenter des contraintes.

## Revendications

1. Procédé de fabrication d'un transistor MOS, **caractérisé en ce qu'**il comprend :
a) la formation, au-dessus d'un substrat (2), d'une couche semi-conductrice intermédiaire (6) contenant un alliage de silicium et de germanium,
b) la réalisation des régions (11, 12, 9) de source, de drain et de grille isolée du transistor, au-dessus de la couche intermédiaire (6),
c) l'oxydation de la couche intermédiaire (6) à partir de sa surface inférieure de façon à augmenter la concentration de germanium dans la région de la couche semi-conductrice intermédiaire (6) située sous l'isolant de grille, et formant ainsi le canal du transistor.

2. Procédé selon la revendication précédente dans lequel l'étape b) comprend la formation d'une couche supérieure (7) sur la couche intermédiaire (6) et la réalisation des régions (11, 12, 9) de source, de drain et de grille isolée sur ladite couche supérieure (7).

3. Procédé selon la revendication 2 dans lequel la couche supérieure (7) est une couche de silicium formée par épitaxie et présentant une épaisseur inférieure à 4nm.

4. Procédé selon l'une des revendications 1 à 3 dans lequel la surface inférieure de la couche intermédiaire (6) repose sur une couche sacrificielle (5, 5') formée au-dessus du substrat (2) et dans lequel l'étape c) comprend :
- la gravure de la couche sacrificielle (5, 5') de manière à obtenir un tunnel (50) exposant la surface inférieure de la couche intermédiaire (6), et
- l'oxydation, dans le tunnel (50), de la surface inférieure de la couche intermédiaire (6).

5. Procédé selon la revendication 4 dans lequel, après l'oxydation de la surface inférieure de la couche intermédiaire (6), on remplit le tunnel (50) avec un matériau diélectrique (18).

6. Procédé selon la revendication 4 ou 5 dans lequel la couche sacrificielle (5) comprend du silicium et est formée sur une première couche (4) contenant un alliage de silicium et de germanium.

7. Procédé selon la revendication 6 dans lequel :
- l'étape a) comprend la formation de la première couche (4), de la couche sacrificielle (5) et de la couche intermédiaire (6) par une épitaxie sans facette, et
- la gravure de la couche sacrificielle (5) comporte une gravure sélective par rapport à la première couche (4) et à la couche intermédiaire (6).

8. Procédé selon la revendication 4 dans lequel la couche sacrificielle (5') est une couche diélectrique formée au-dessus du substrat (2).

9. Procédé selon l'une des revendications précédentes dans lequel la couche intermédiaire (6) présente une épaisseur comprise entre 5nm et 15nm, de préférence inférieure à 10nm, et une proportion de germanium comprise entre 30% et 90%, de préférence supérieure à 50%.

## Claims

1. Method for fabricating an MOS transistor, **characterized in that** it comprises:
a) the formation of a semiconducting intermediate layer (6) containing an alloy of silicon and germanium above a substrate (2),
b) production of the source, drain and insulated gate regions (11, 12, 9) of the transistor, above the intermediate layer (6),
c) oxidation of the intermediate layer (6) starting from its lower surface so as to increase the concentration of germanium in the region of semiconducting intermediate layer (6) situated under the gate isolator, and thus forming the channel of the transistor.

2. Method according to the preceding claims, wherein step b) comprises the formation of an upper layer (7) on the intermediate layer (6) and production of the source, drain and insulated gate regions (11, 12, 9) on the said upper layer.

3. Method according to Claim 2, wherein the upper layer (7) is a silicon layer formed by epitaxy and having a thickness of less than 4 nm.

4. Method according to one of Claims 1 to 3, wherein the lower surface of the intermediate layer (6) rests on a sacrificial layer (5, 5') formed above the substrate (2) and wherein step c) comprises:
- etching of the sacrificial layer (5, 5') so as to obtain a tunnel (50) exposing the lower surface of the intermediate layer (6), and
- oxidation of the lower surface of the intermediate layer (6) in the tunnel (50).

5. Method according to claim 4, wherein after oxidation of the lower surface of the intermediate layer (6), the tunnel (50) is filled with a dielectric material (18).

6. Method according to claim 4 or 5, wherein the sacrificial layer (5) comprises silicon and is formed on a first layer (4) containing an alloy of silicon and germanium.

7. Method according to claim 6, wherein:
- step a) comprises formation of the first layer (4), of the sacrificial layer (5) and of the intermediate layer (6) by facetless epitaxy, and
- the etching of the sacrificial layer (5) involves selective etching with respect to the first layer (4) and with respect to the intermediate layer (6).

8. Method according to claim 4, wherein the sacrificial layer (5') is a dielectric layer formed above the substrate (2).

9. Method according to one of the preceding claims, wherein the intermediate layer (6) has a thickness of between 5 nm and 15 nm, preferably less than 10 nm, and a germanium proportion of between 30% and 90%, preferably more than 50%.

## Patentansprüche

1. Verfahren zur Herstellung eines MOS-Transistors, **dadurch gekennzeichnet, daß** es aufweist:
a) die Herstellung einer Halbleiter-Zwischenschicht (6), die eine Legierung aus Silizium und Germanium enthält, oberhalb eines Substrats (2),
b) die Herstellung von Source-, Drain- und isolierten Gate-Bereichen (11,12,9) des Transistors oberhalb der Zwischenschicht (6),
c) die Oxidation der Zwischenschicht (6) von ihrer unteren Oberfläche aus, derart, um die Germanium-Konzentration in dem unterhalb der Gate-Isolierung angeordneten Bereich der Halbleiter-Zwischenschicht (6) zu erhöhen und **dadurch** den Kanal des Transistors zu bilden.

2. Verfahren nach dem vorstehenden Anspruch, in welchem der Schritt b) die Bildung einer oberen Schicht (7) oberhalb der Zwischenschicht (6) und die Herstellung von Source-, Drain und isolierten Gate-Bereichen (11,12,9) oberhalb der oberen Schicht (7) aufweist.

3. Verfahren nach Anspruch 2, in welchem die obere Schicht (7) eine mittels Epitaxie gebildete Siliziumschicht ist, deren Dicke kleiner als 4nm ist.

4. Verfahren nach einem der Ansprüche 1 bis 3, in welchem die untere Oberfläche der Zwischenschicht (6) auf einer oberhalb des Substrats (2) gebildeten Opferschicht (5,5') aufliegt und in welchem der Schritt c) aufweist:
- die Ätzung der Opferschicht (5,5') derart, um einen Tunnel (50) zu erzeugen, der die untere Oberfläche der Zwischenschicht (6) freilegt, und
- in dem Tunnel (5) die Oxidation der unteren Oberfläche der Zwischenschicht (6).

5. Verfahren nach Anspruch 4, in welchem nach der Oxidation der unteren Oberfläche der Zwischenschicht (6) der Tunnel (50) mit einem dielektrischen Material (18) gefüllt wird.

6. Verfahren nach Anspruch 4 oder 5, in welchem die Opferschicht (5) Silizium aufweist und auf einer ersten Schicht (4) gebildet ist, die eine Legierung aus Silizium und Germanium enthält.

7. Verfahren nach Anspruch 6, in welchem
- der Schritt a) die Herstellung der ersten Schicht (4), der Opferschicht (5) und der Zwischenschicht (6) mittels Epitaxie ohne Facette aufweist und
- die Ätzung der Opferschicht (5) ein selektives Ätzen in bezug auf die erste Schicht (4) und die Zwischenschicht (6) aufweist.

8. Verfahren nach Anspruch 4, in welchem die Opferschicht (5') eine oberhalb des Substrats (2) gebildete dielektrische Schicht ist.

9. Verfahren nach einem der vorstehenden Ansprüche, in welchem die Zwischenschicht (6) eine Dicke zwischen 5nm und 15nm, vorzugsweise von weniger als 10nm, aufweist und einen Anteil an Germanium zwischen 30% und 90%, vorzugsweise von mehr als 50%, aufweist.
